# FASCICULE DE BREVET EUROPEEN

(11) **EP 2 867 498 B1**
(45) Date de publication et mention de la délivrance du brevet: **22.03.2017**
(21) Numéro de dépôt: 13744665.4
(22) Date de dépôt: 28.06.2013
(51) Int. Cl.: F02C 7/057, H05K 7/20

(54) **DISPOSITIF DE VENTILATION ET D'ALIMENTATION ÉLECTRIQUE D'UN CALCULATEUR DE MOTEUR D'AÉRONEF**
VORRICHTUNG ZUR BELÜFTUNG UND STROMVERSORGUNG EINES FLUGZEUGMOTORCOMPUTERS
DEVICE FOR VENTILATING AND SUPPLYING ELECTRICAL POWER TO AN AIRCRAFT ENGINE COMPUTER

(30) Priorité: 02.07.2012 FR 1256337
(43) Date de publication de la demande: 06.05.2015
(73) Titulaire: SNECMA, 75015 Paris (FR)
(72) Inventeur: LEPAGE, Thomas, F-77550 Moissy Cramayel Cedex (FR); GAULLY, Bruno, Robert, F-77550 Moissy Cramayel Cedex (FR)
(74) Mandataire: Jolly, Christophe
(86) Numéro de dépôt international: PCT/FR2013/051529
(87) Numéro de publication internationale: WO 2014/006309

(56) Documents cités:
- EP-A1- 0 111 437
- EP-A1- 1 610 606
- EP-B1- 0 213 019
- US-A- 4 601 202
- US-A1- 2011 271 655

## Description

La présente invention concerne un dispositif de ventilation et d'alimentation électrique d'un calculateur de moteur d'aéronef, en particulier d'un turboréacteur ou turbopropulseur d'avion.

Un calculateur de ce type, couramment appelé ECU (acronyme de *Electronic Control Unit*) dans le domaine aéronautique, a pour fonction de réguler la puissance et la vitesse de rotation du moteur en fonction de plusieurs paramètres.

Ce calculateur est relié par des moyens de connexion/déconnexion à des moyens d'alimentation électrique de l'aéronef et à un alternateur à aimant permanent ou PMA (acronyme de *Permanent Magnet Alternator*) qui est monté dans le boîtier d'accessoires ou AGB (acronyme de *Accessory Gear Box*) du moteur. Lorsque l'aéronef est au sol, le calculateur est alimenté électriquement par les moyens d'alimentation de l'aéronef et, lorsque l'aéronef est en vol, le calculateur est alimenté par le PMA. Le PMA est toutefois un équipement encombrant qui occupe une place relativement importante dans l'AGB.

Le calculateur est refroidi par de l'air de ventilation qui est amené au voisinage du calculateur ou dans une enceinte contenant le calculateur. Dans la technique actuelle, le moteur comporte une écope de collecte d'une partie du flux d'air s'écoulant à l'extérieur du moteur, cet air prélevé étant guidé dans un conduit jusqu'au calculateur. Cependant, le débit d'air prélevé dépend notamment des dimensions de l'écope dont le surdimensionnement entraîne une augmentation de la traînée correspondante et donc une augmentation de la consommation spécifique du moteur. Par ailleurs, ces moyens de ventilation ne sont efficaces que lorsque l'aéronef est en vol. Lorsque l'aéronef est immobilisé au sol, aucun débit d'air n'est prélevé par l'écope et le calculateur n'est pas refroidi alors que celui-ci doit rester opérationnel pendant certaines phases de maintenance et lorsque le moteur est arrêté mais continue d'émettre de la chaleur par rayonnement (appelé phénomène « *soack-back »*).

On a déjà proposé de refroidir un calculateur au moyen d'un ventilateur à hélice, en particulier lorsque l'aéronef est immobilisé au sol. Le rotor du ventilateur est entraîné par un moteur qui est alimenté et piloté par le calculateur. Cependant, lorsque l'aéronef est en vol, le calculateur est toujours alimenté par le PMA qui est encombrant.

Le document EP 0 213 019 B1 concerne des supports de dispositifs électroniques.

Il est connu du document EP 0111437 A1 des dispositifs électroniques agencés dans un moteur d'avion.

Le document EP 1 610 606 A1 concerne un dispositif de contrôle d'un fluide servant à chauffer ou refroidir un système électronique d'un moteur d'avion.

La présente invention a notamment pour but d'apporter une solution simple, efficace et économique aux problèmes de la technique antérieure.

Elle propose à cet effet un dispositif de ventilation et d'alimentation électrique d'un calculateur de moteur d'aéronef, comprenant une hélice reliée à des moyens d'entraînement et apte à générer un flux d'air de ventilation du calculateur, et des moyens d'amenée d'air à proximité du calculateur, caractérisé en ce que l'hélice est montée dans les moyens d'amenée d'air ou en sortie de ces moyens, et en ce que les moyens d'entraînement comportent une machine électrique apte à fonctionner en moteur pour entraîner l'hélice lorsque l'aéronef est au sol, de manière à générer le flux d'air de ventilation du calculateur, et en générateur pour alimenter électriquement le calculateur lorsque l'aéronef est en vol, le rotor de la machine électrique fonctionnant en générateur étant entraîné par l'hélice qui est elle-même entraînée par un flux d'air prélevé à l'extérieur du moteur lorsque l'aéronef est en vol, et circulant ou sortant des moyens d'amenée d'air.

Dans le dispositif selon l'invention, l'hélice est configurée pour fonctionner en turbine lorsque l'aéronef est en vol et en compresseur lorsque l'aéronef est au sol. Lorsque l'hélice fonctionne en turbine, elle est entraînée par le flux d'air circulant dans les moyens d'amenée d'air jusqu'au calculateur, et entraîne à son tour le rotor de la machine électrique qui fonctionne alors en générateur de courant ou de tension pour l'alimentation du calculateur. Lorsque l'hélice fonctionne en compresseur, elle génère un flux d'air de ventilation du calculateur et elle est entraînée par le rotor de la machine électrique qui fonctionne en moteur et qui peut être pilotée par le calculateur et reliée à des moyens d'alimentation électrique de l'aéronef.

Le dispositif selon l'invention permet ainsi d'assurer la ventilation du calculateur ainsi que son alimentation électrique, sans utilisation d'un PMA. Le PMA de la technique antérieure n'est donc pas nécessairement monté dans l'AGB, ce qui libère une place significative dans l'AGB pour l'installation d'un autre équipement. L'entrainement PMA via l'AGB peut être remplacé par un entrainement pneumatique. Le PMA peut être doté d'une fonction moteur pour assurer la fonction de ventilation du calculateur. Ce PMA bi-fonction permet alors de se passer d'un moteur de ventilateur dédié. Par ailleurs, en mode alternateur, l'entrainement étant réalisé avec de l'air, cela permet la suppression d'une ligne dans la boite de transmission du moteur, et se traduit donc par un gain masse et d'encombrement.

L'invention permet donc d'apporter une solution aux deux problèmes précités de refroidissement du calculateur au sol et d'encombrement du PMA d'alimentation électrique du calculateur en vol.

La machine électrique peut être un moteur sans balais à aimant permanent, alimenté par exemple par un stator triphasé. Dans le cas où cette machine est reliée à des moyens d'alimentation électrique de l'aéronef pour son alimentation au sol, ces moyens d'alimentation peuvent également être du type triphasé. La machine électrique fonctionnant en mode turbine éolienne ou en mode compresseur ventilateur consomme une puissance électrique proche de celle à générer pour le fonctionnement du calculateur et qui est de l'ordre de 100-300W et par exemple de 150-200W.

La machine électrique comprend avantageusement deux stators reliés électriquement au calculateur par des voies indépendantes. Cette redondance permet d'améliorer la fiabilité du dispositif, en particulier lorsque la fonction générateur est active. Lorsque la machine électrique fonctionne en génératrice, chaque stator alimente une voie reliée au calculateur. En cas de défaillance de l'une de ces voies, l'autre voie assure l'alimentation électrique du calculateur. Lorsque la machine électrique fonctionne en moteur, une seule voie peut être utilisée pour alimenter la machine électrique.

L'hélice comporte des pales radiales à pas angulaire fixe ou à pas variable autour de leurs axes radiaux respectifs.

Dans le cas où les pales de l'hélice sont fixes, elles peuvent avoir une orientation qui est déterminée pour optimiser l'une des deux fonctions précitées (compresseur ou turbine) ou qui représente un compromis entre ces deux fonctions.

Dans le cas où les pales de l'hélice sont du type à pas variable, la machine électrique peut comprendre un rotor mobile en translation à l'intérieur du stator et dont une extrémité est reliée à des moyens d'actionnement et de pivotement des pales autour de leurs axes, et l'autre extrémité est reliée à un régulateur à boules.

Le fonctionnement d'un régulateur à boules est bien connu d'un homme du métier. Le régulateur à boules est configuré pour déplacer le rotor en translation dans le stator de la machine électrique en fonction de sa vitesse de rotation. Lorsque la vitesse de rotation du régulateur à boules est relativement faible, le régulateur est dans une première position où ses boules sont rapprochées l'une de l'autre et le rotor est situé à une extrémité axiale du stator. Lorsque la vitesse de rotation du régulateur à boules est relativement importante, le régulateur est dans une seconde position où ses boules sont éloignées l'une de l'autre et le rotor est situé à l'extrémité axiale opposée du stator. Ces vitesses sont notamment fonction des dimensions de la machine électrique. C'est l'augmentation de la vitesse de rotation du régulateur et donc des boules qui entraîne un déplacement des boules radialement vers l'extérieur (du fait des forces centrifuges) et une translation axiale du rotor.

En variante, la machine électrique peut comprendre un rotor dont une extrémité est entourée par un moyeu de support des pales et autour duquel un anneau est monté mobile en rotation et est relié par des biellettes à des moyens de pivotement des pales autour de leurs axes radiaux respectifs, le moyeu étant déplaçable en rotation autour du rotor qui comporte au moins un doigt radial traversant une lumière circonférentielle du moyeu et un orifice de l'anneau, le débattement angulaire de l'anneau autour du moyeu étant fonction du débattement angulaire du doigt radial du rotor dans la lumière du moyeu.

L'anneau peut être centré et guidé en rotation autour du moyeu. Le rotor peut comporter deux doigts radiaux diamétralement opposés et traversant chacun une lumière circonférentielle du moyeu et un orifice de l'anneau. Les doigts radiaux du rotor sont engagés sensiblement sans jeu dans les orifices de l'anneau. Les lumières du moyeu ont des dimensions circonférentielles déterminées en fonction des débattements angulaires précités, qui sont de l'ordre de 20-60°.

Le déplacement des doigts radiaux dans les lumières du moyeu provoquent le déplacement des pales en rotation autour de leurs axes. Dans une première position où chaque doigt radial est situé à une extrémité circonférentielle de la lumière correspondante, les pales de l'hélice peuvent avoir une orientation optimale pour le fonctionnement de l'hélice comme compresseur et, dans une seconde position opposée où chaque doigt radial est situé à l'extrémité opposée de la lumière, les pales de l'hélice peuvent avoir une orientation optimale pour le fonctionnement de l'hélice comme turbine. Le rotor du moteur/générateur doit être entraîné en rotation dans un premier sens, par exemple horaire, pour que les doigts radiaux soient dans la première position précitée et entraînent en rotation le moyeu, l'anneau et les pales pour fonctionner comme compresseur, et dans le sens opposé (antihoraire) pour que les doigts radiaux soient dans la seconde position précitée et entraînent en rotation le moyeu, l'anneau et les pales pour fonctionner comme turbine.

La présente invention concerne également un procédé d'utilisation du dispositif tel que décrit ci-dessus, caractérisé en ce que, lorsque l'aéronef est en vol, l'air circulant dans les moyens d'amenée traverse et entraîne en rotation l'hélice qui entraîne à son tour en rotation le rotor de la machine électrique pour alimenter le calculateur qui est refroidi par l'air sortant des moyens d'amenée et, lorsque l'aéronef est au sol, des moyens d'alimentation électrique de l'aéronef alimentent le calculateur et la machine électrique pour l'entraînement de l'hélice qui génère un flux d'air de ventilation du calculateur.

L'invention sera mieux comprise et d'autres caractéristiques, détails et avantages de celle-ci apparaîtront plus clairement à la lecture de la description qui suit, faite à titre d'exemple non limitatif et en référence aux dessins annexés dans lesquels :
- la figure 1 est une vue très schématique d'un dispositif de ventilation et d'alimentation électrique d'un calculateur de moteur d'aéronef, selon la technique antérieure ;
- la figure 2 est une vue schématique d'un autre dispositif de ventilation et d'alimentation électrique d'un calculateur de moteur d'aéronef, selon la technique antérieure ;
- la figure 3 est une vue schématique d'un dispositif de ventilation et d'alimentation électrique d'un calculateur de moteur d'aéronef, selon l'invention ;
- les figures 4 et 5 sont des vues schématiques en coupe axiale d'une machine électrique pour un dispositif selon l'invention, et représentent respectivement deux positions axiales différentes du rotor dans le stator de cette machine ;
- la figure 6 est une vue schématique en coupe axiale d'une variante de réalisation de la machine électrique pour un dispositif selon l'invention ; et
- la figure 7 est une vue en coupe selon la ligne AA de la figure 6.

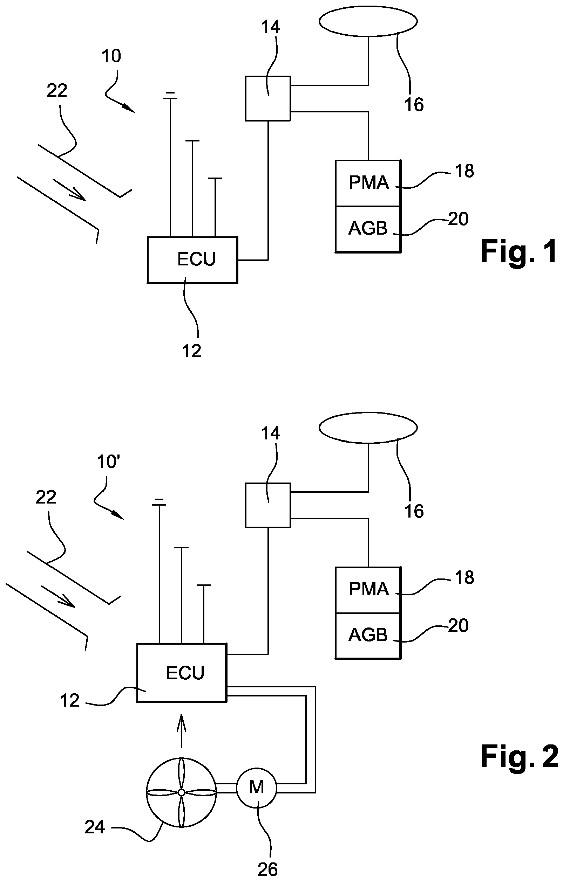

On se réfère d'abord à la figure 1 qui représente un dispositif 10 selon la technique antérieure de ventilation et d'alimentation électrique d'un calculateur 12 (ECU) de moteur d'aéronef, et en particulier d'une turbomachine d'avion, telle qu'un turbopropulseur ou un turboréacteur.

Le calculateur 12 est relié électriquement par des moyens 14 de connexion/déconnexion à des moyens 16 d'alimentation électrique de l'aéronef et à un PMA 18 qui est monté dans l'AGB 20 du moteur et dont le rotor est entraîné par cet AGB.

La turbomachine comprend une écope (non représentée) de prélèvement d'une partie du flux d'air s'écoulant autour du moteur lorsque l'aéronef est en vol, cette écope étant reliée à des moyens 22 d'amenée d'air jusqu'au calculateur 12 pour son refroidissement.

En vol, le calculateur 12 est alimenté par le PMA 18 et est refroidi par le flux d'air délivré par les moyens d'amenée 22. Au sol, le calculateur 12 est alimenté par les moyens d'alimentation 16 de l'aéronef et n'est pas refroidi, ce qui est problématique.

La figure 2 représente un autre dispositif 10' de la technique antérieure de ventilation et d'alimentation électrique d'un calculateur 12 de moteur d'aéronef, ce dispositif différant de celui de la figure 1 en ce qu'il comprend en outre un ventilateur 24 de génération d'un flux d'air de ventilation du calculateur 12 lorsque l'aéronef est au sol.

L'hélice du ventilateur 24 est entraînée en rotation par un moteur 26 qui est piloté par le calculateur 12.

En vol, le calculateur 12 est alimenté par le PMA 18 et est refroidi par le flux d'air délivré par les moyens d'amenée 22. Au sol, le calculateur 12 est alimenté par les moyens d'alimentation 16 de l'aéronef et est refroidi par le flux d'air délivré par le ventilateur 14.

Cependant, le problème d'encombrement du PMA n'est pas résolu car le PMA est toujours nécessaire dans la technique antérieure pour assurer l'alimentation électrique du calculateur 112 en vol. De plus, le moteur 26 est dédié pour entrainer le ventilateur 24.

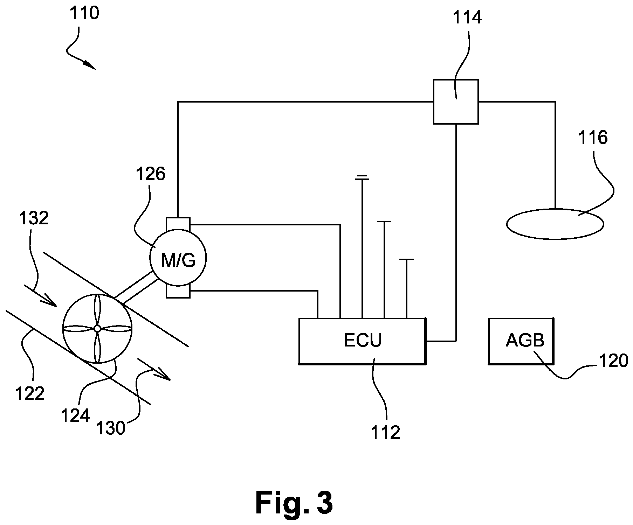

L'invention permet de remédier à ce problème grâce au dispositif 110 de la figure 3 qui comprend un calculateur 112 (ECU), une hélice 124 de ventilateur montée dans les moyens 122 d'amenée d'air et configurée pour fonctionner en turbine ou en compresseur, et une machine électrique 126 (M/G) qui est apte à alimenter électriquement le calculateur 112 lorsque l'hélice fonctionne en turbine et pour entraîner en rotation l'hélice lorsque cette dernière fonctionne en compresseur.

Le calculateur 112 et la machine électrique 126 sont reliés par des moyens 114 de connexion/déconnexion aux moyens 116 d'alimentation électrique de l'aéronef. L'AGB 120 ne comporte pas de PMA, dont l'entraînement est mécanique du PMA (pas de ligne dédiée).

Lorsque l'aéronef est au sol, les moyens 116 alimentent la machine électrique 126 (qui fonctionne en moteur) et le calculateur 112 est refroidi par le flux d'air 130 délivré par l'hélice 124 (qui fonctionne comme un compresseur). L'hélice 124 est solidaire du rotor de la machine électrique 126 dont la rotation est pilotée et régulée par le calculateur 112.

La machine électrique 126 est de préférence un moteur sans balais à aimant permanent dont le stator est alimenté par un réseau triphasé de l'aéronef. La puissance fournie à cette machine est par exemple de l'ordre de 150W.

La machine électrique 126 comprend avantageusement deux stators indépendants reliés électriquement au calculateur 112 par des voies indépendantes. Une seule de ces voies peut être utilisée pour l'alimentation électrique de la machine 126.

Lorsque l'aéronef est en vol, le calculateur 112 est alimenté par la machine électrique 126 (qui fonctionne en génératrice) et est refroidi par le flux d'air 132 sortant des moyens 122 d'amenée d'air, qui sont reliés en amont à des moyens de prélèvement d'air du type écope par exemple. Ce flux d'air 132 passe à travers l'hélice 124 et l'entraîne en rotation autour de son axe avant de servir à la ventilation du calculateur 112. L'hélice 124 fonctionne alors en turbine qui est entraînée par le flux d'air 132 et qui entraîne à son tour le rotor de la machine électrique 126 pour générer un courant ou une tension électrique d'alimentation du calculateur 112.

Dans le cas où la machine électrique 126 comprend deux stators indépendants reliés électriquement au calculateur 112 par des voies indépendantes, ces deux voies sont utilisées pour alimenter le calculateur et pallier le risque de défaillance de l'une de ces voies. La puissance de la machine électrique 126 délivrée au calculateur est par exemple de l'ordre de 200W.

Comme cela est décrit dans ce qui précède, l'hélice 124 assure une double fonction de turbine et de compresseur selon qu'elle est entraînée par l'air circulant dans les moyens 122 ou par la machine électrique 126.

Pour cela, l'hélice 124 peut comporter des pales fixes, c'est-à-dire que le pas angulaire de chaque pale autour de son axe radial est figé. Ce pas peut être déterminé pour optimiser l'une des deux fonctions précitées (compresseur ou turbine) ou peut représenter un compromis entre ces deux fonctions. La rotation de l'hélice dans un sens (par exemple horaire) autour de son axe permet de fonctionner comme compresseur et de générer un flux d'air, et la fourniture d'un flux d'air en amont de l'hélice permet de la faire tourner et de la faire fonctionner comme turbine d'entraînement du rotor de la machine électrique.

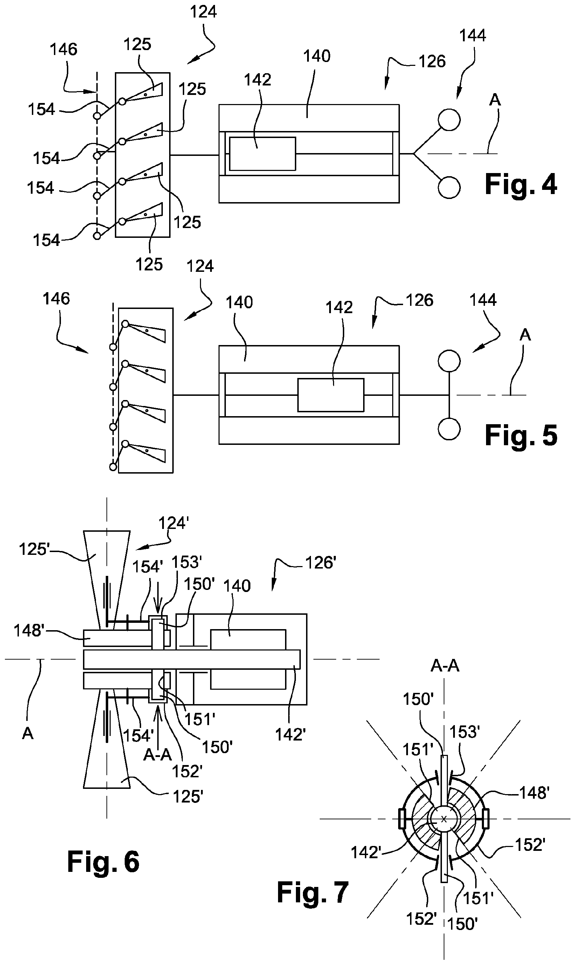

En variante, l'hélice comporte des pales à pas variable. Les figures 4 et 5 d'une part, et 6 et 7 d'autre part, représentent deux modes de réalisation différents de cette hélice et de la machine électrique associée.

Dans le mode de réalisation des figures 4 et 5, la machine électrique 126 comprend un stator 140 et un rotor 142 mobile en translation axiale à l'intérieur du stator et ayant une dimension axiale inférieure à celle du stator.

Le rotor 142 a une extrémité axiale reliée à un régulateur à boules 144, son extrémité opposée étant reliée à des moyens d'actionnement et de pivotement des pales 125 de l'hélice 124.

Le régulateur à boules 144 comprend au moins deux boules réparties sur une circonférence centrée sur l'axe longitudinal A du rotor du moteur/générateur 126 et reliées chacune à une extrémité d'une tige dont l'extrémité opposée est articulée autour d'un axe perpendiculaire à l'axe A à l'extrémité précitée du rotor. Lorsque le rotor 142 de la machine électrique 126 tourne, les boules sont sollicitées vers l'extérieur par les forces centrifuges et sont déplaçables d'une première position représentée en figure 4 où elles sont rapprochées l'une de l'autre et de l'axe A, à une seconde position représentée en figure 5 où elles sont éloignées l'une de l'autre et de l'axe A.

Dans l'exemple représenté, les moyens 146 d'actionnement des pales 125 comprennent un anneau d'axe A relié à l'extrémité du rotor 142 opposée au régulateur à boules 144, et raccordé par des biellettes 154 aux pales 125, qui sont chacune mobiles en rotation autour d'un axe radial.

Le déplacement des boules de la première à la seconde position provoque un déplacement du rotor 142 d'une extrémité du stator 140 à l'extrémité opposée du stator, et un pivotement des pales autour de leurs axes radiaux, comme cela est visible aux figures 4 et 5.

Dans la variante de réalisation des figures 6 et 7, la machine électrique 126' comprend un stator 140' et un rotor 142' dont une extrémité s'étend au-delà du stator et est entourée par un moyeu 148' qui porte les pales 125' de l'hélice 124' et qui est libre en rotation sur cette extrémité du rotor sur une plage angulaire prédéterminée.

Le rotor 142' est solidaire de deux doigts radiaux 150' qui sont diamétralement opposés et sont engagés dans des lumières radiales 151' traversantes du moyeu. Ces lumières 151' ont une orientation circonférentielle et chaque doigt 150' est mobile en direction circonférentielle dans une de ces lumières, entre une première position (représentée en figure 7) où il prend appui sur l'une des extrémités circonférentielles de la lumière et une seconde position où il prend appui sur l'extrémité circonférentielle opposée de la lumière. Le débattement angulaire des doigts dans les lumières est fonction des dimensions circonférentielles des lumières, et est par exemple de l'ordre de 30-60°.

Le moyeu 148' est entouré par un anneau 152' qui est centré et guidé en rotation sur le moyeu autour de l'axe longitudinal A de la machine électrique 126'. L'anneau 152' comprend des orifices radiaux 153' traversés par les extrémités libres des doigts 150', pour l'entraînement en rotation de l'anneau autour de l'axe A sur la plage angulaire précitée. L'anneau 152' est relié par des biellettes 154' (par exemple en forme de L), à des moyens d'entraînement des pales autour de leurs axes.

Le déplacement des doigts radiaux 150' dans les lumières 151' du moyeu 148' provoquent une rotation de l'anneau 152' vis-à-vis du moyeu 148' et un pivotement des pales 125' autour de leurs axes. A titre d'exemple, lorsque le rotor 142' de la machine électrique 126' est déplacé dans le sens horaire, les doigts radiaux 150' viennent dans la seconde position précitée et les pales de l'hélice 124' sont orientées de façon à ce que le fonctionnement en compresseur de l'hélice soit optimisé. La rotation de l'hélice dans le sens horaire permet alors de générer un flux d'air de ventilation. Lorsque le rotor 142' est déplacé dans le sens antihoraire, les doigts radiaux 150' viennent dans la première position précitée et les pales de l'hélice 124' sont orientées de façon à ce que le fonctionnement en turbine de l'hélice soit optimisé. Le flux d'air traversant l'hélice l'entraîne alors dans le sens antihoraire.

## Revendications

1. Dispositif (110) de ventilation et d'alimentation électrique d'un calculateur (112) de moteur d'aéronef, comprenant une hélice (124) entraînée par des moyens moteurs (126) et apte à générer un flux d'air (130) de ventilation du calculateur, et des moyens (122) d'amenée d'air à proximité du calculateur, **caractérisé en ce que** l'hélice est montée dans les moyens d'amenée d'air ou en sortie de ces moyens, et **en ce que** les moyens moteurs comportent une machine électrique (126) apte à fonctionner en moteur pour entraîner l'hélice lorsque l'aéronef est au sol, de manière à générer le flux d'air (130) de ventilation du calculateur, et en générateur pour alimenter électriquement le calculateur lorsque l'aéronef est en vol, le rotor de cette machine électrique fonctionnant en générateur étant entraîné par l'hélice qui est elle-même entraînée par un flux d'air prélevé à l'extérieur du moteur lorsque l'aéronef est en vol, et circulant ou sortant des moyens d'amenée d'air.

2. Dispositif selon la revendication 1, **caractérisé en ce que** la machine électrique (126) est un moteur sans balais à aimant permanent, par exemple à stator triphasé.

3. Dispositif selon la revendication 1 ou 2, **caractérisé en ce que** la machine électrique (126) est reliée à des moyens (116) d'alimentation électrique de l'aéronef pour son fonctionnement en moteur au sol.

4. Dispositif selon l'une des revendications précédentes, **caractérisé en ce que** la machine électrique (126) est pilotée par le calculateur (112) et a une puissance de l'ordre de 100-300W et par exemple de 150-200W.

5. Dispositif selon l'une des revendications précédentes, **caractérisé en ce que** la machine électrique (126) comprend deux stators reliés électriquement au calculateur (112) par des voies indépendantes.

6. Dispositif selon l'une des revendications précédentes, **caractérisé en ce que** l'hélice (124) comporte des pales radiales à pas angulaire fixe ou à pas variable.

7. Dispositif selon l'une des revendications précédentes, **caractérisé en ce que** l'hélice (124) est du type à pales à pas variable, la machine électrique (126) comprenant un rotor (142) mobile en translation à l'intérieur du stator (140) et dont une extrémité est reliée à des moyens (146) d'actionnement et de pivotement des pales autour de leurs axes, et l'autre extrémité est reliée à un régulateur à boules (144).

8. Dispositif selon l'une des revendications précédentes, **caractérisé en ce que** l'hélice (124') est du type à pales à pas variable, la machine électrique (126') comprenant un rotor (142') dont une extrémité est entourée par un moyeu (148') de support des pales et autour duquel un anneau (152') est monté mobile en rotation et est relié par des biellettes (154') à des moyens de pivotement des pales autour de leurs axes radiaux respectifs, le moyeu étant déplaçable en rotation autour du rotor qui comporte au moins un doigt (150') radial traversant une lumière (151') circonférentielle du moyeu et un orifice ('153') de l'anneau, le débattement angulaire de l'anneau autour du moyeu étant fonction du débattement angulaire du doigt radial du rotor dans la lumière du moyeu.

9. Dispositif selon la revendication 8, **caractérisé en ce que** le rotor (142') comporte deux doigts radiaux (150') diamétralement opposés et traversant chacun une lumière (151') circonférentielle du moyeu (148') et un orifice (153') de l'anneau (152').

10. Procédé d'utilisation du dispositif selon l'une des revendications précédentes, **caractérisé en ce que**, lorsque l'aéronef est en vol, l'air circulant dans les moyens d'amenée (122) traverse et entraîne en rotation l'hélice (124) qui entraîne à son tour en rotation le rotor de la machine électrique (126) pour alimenter le calculateur (112) qui est refroidi par l'air sortant des moyens d'amenée et, lorsque l'aéronef est au sol, des moyens (116) d'alimentation électrique de l'aéronef alimentent le calculateur et la machine électrique pour l'entraînement de l'hélice qui génère un flux d'air de ventilation du calculateur.

## Patentansprüche

1. Elektrische Lüftungs- und Stromversorgungsvorrichtung (110) einer Motorsteuerung eines Luftfahrzeugs, welche einen Propeller (124) umfasst, der durch Antriebsmittel (126) angetrieben wird und in der Lage ist, einen Belüftungsluftstrom (130) für die Steuerung zu erzeugen, und Luftzufuhrmittel (122) in der Nähe der Steuerung, **dadurch gekennzeichnet, dass** der Propeller in die Luftzufuhrmittel oder am Austritt dieser Mittel montiert wird, und dadurch, dass die Antriebsmittel eine elektrische Maschine (126) enthalten, die in der Lage ist, als Motor zu fungieren, um den Propeller anzutreiben, wenn das Luftfahrzeug am Boden steht, so dass ein Belüftungsluftstrom (130) für die Steuerung erzeugt wird, und als Generator, um die Steuerung mit Strom zu versorgen, wenn das Luftfahrzeug fliegt, wobei der Rotor dieser als Generator dienenden elektrischen Maschine durch den Propeller angetrieben wird, welcher wiederum durch einen außerhalb des Motors strömenden Luftstrom angetrieben wird, wenn das Luftfahrzeug fliegt, wobei dieser Luftstrom durch die Luftzufuhrmittel strömt oder dort austritt.

2. Vorrichtung nach Anspruch 1, **dadurch gekennzeichnet, dass** die elektrische Maschine (126) ein bürstenloser Motor mit Permanentmagnet, zum Beispiel mit dreiphasiger Ständerwicklung, ist.

3. Vorrichtung nach Anspruch 1 oder 2, **dadurch gekennzeichnet, dass** die elektrische Maschine (126) mit Stromversorgungsmitteln (116) des Luftfahrzeugs verbunden ist, damit deren Funktionsweise als Motor am Boden gewährleistet ist.

4. Vorrichtung nach einem der vorhergehenden Ansprüche, **dadurch gekennzeichnet, dass** die elektrische Maschine (126) durch die Steuerung (112) kontrolliert wird und eine Leistung von circa 100-300W und beispielsweise 150-200W aufweist.

5. Vorrichtung nach einem der vorhergehenden Ansprüche, **dadurch gekennzeichnet, dass** die elektrische Maschine (126) zwei Ständerwicklungen umfasst, die über unabhängige Kanäle elektrisch an die Steuerung (112) angeschlossen sind.

6. Vorrichtung nach einem der vorhergehenden Ansprüche, **dadurch gekennzeichnet, dass** der Propeller (124) radiale Blätter mit fester oder variabler Winkelstellung umfasst.

7. Vorrichtung nach einem der vorhergehenden Ansprüche, **dadurch gekennzeichnet, dass** der Propeller (124) Blätter mit veränderlicher Winkelstellung aufweist, wobei die elektrische Maschine (126) einen translatorisch beweglichen Rotor (142) im Innern der Ständerwicklung (140) umfasst, dessen eines Ende mit den Mitteln zum Betätigen und Drehen der Blätter um ihre Achsen verbunden ist, und dessen anderes Ende mit einem Fliehkraftregler (144) verbunden ist.

8. Vorrichtung nach einem der vorhergehenden Ansprüche, **dadurch gekennzeichnet, dass** der Propeller (124') Blätter mit Winkelverstellung aufweist, wobei die elektrische Maschine (126') einen Rotor (142') umfasst, dessen eines Ende von einer Haltenabe (148') der Blätter umgeben ist, und um welches ein Ring (152') drehbar gelagert ist, und über Schwingarme (154') mit Mitteln zum Drehen der Blätter um ihre jeweiligen radialen Achsen verbunden ist, wobei die Nabe um den Rotor gedreht werden kann und dieser mindestens einen radialen Finger (150') aufweist, welcher durch eine Umfangsöffnung (14512') der Nabe und eine Öffnung (153') des Rings führt, wobei der Winkelausschlag des Rings um die Nabe vom Winkelausschlag des radialen Fingers des Rotors in der Öffnung der Nabe abhängt.

9. Vorrichtung nach Anspruch 8, **dadurch gekennzeichnet, dass** der Rotor (142') zwei radiale Finger (150') enthält, die diametral entgegengesetzt sind und jeweils durch eine Umfangsöffnung (151') der Nabe (148') und eine Öffnung (153') des Rings (152) führen.

10. Verfahren zur Benutzung der Vorrichtung nach einem der vorhergehenden Ansprüche, **dadurch gekennzeichnet, dass**, wenn das Luftfahrzeug fliegt, die durch die Zufuhrmittel (122) strömende Luft durch den Propeller (124) strömt und diesen in Rotation versetzt, wobei dieser wiederum den Rotor der elektrischen Maschine (126) in Rotation versetzt, um die Steuerung (112), die durch die aus den Zufuhrmitteln austretende Luft abgekühlt wird, mit Strom zu versorgen und, wenn das Luftfahrzeug am Boden steht, die elektrischen Stromversorgungsmittel (116) die Steuerung und die elektrische Maschine mit Strom versorgen, um den Propeller, welcher einen Belüftungsluftstrom der Steuerung erzeugt, anzutreiben.

## Claims

1. A device (110) for ventilating and electrically powering a computer (112) of an engine of an aircraft, the device comprising means (122) for feeding air to the proximity of the computer and a fan (124) driven by motor means (126) and suitable for generating an air stream (130) for ventilating the computer, the device being **characterized in that** the fan is mounted in the air feed means or at the outlet from said means, and **in that** the motor means comprise an electrical machine (126) suitable for operating as a motor to drive the fan when the aircraft is on the ground so as to generate the stream of air (130) for ventilating the computer, and as a generator to power the computer electrically while the aircraft is in flight, the rotor of the electrical machine operating as a generator being driven by the fan, which is itself driven by a stream of air taken from outside the engine when the aircraft is in flight, and flowing along or leaving the air feed means.

2. A device according to claim 1, **characterized in that** the electrical machine (126) is a brushless permanent magnet motor, e.g. having a three-phase stator.

3. A device according to claim 1 or claim 2, **characterized in that** the electrical machine (126) is connected to electrical power supply means (116) of the aircraft to enable it to operate as a motor on the ground.

4. A device according to any preceding claim, **characterized in that** the electrical machine (126) is controlled by the computer (112) and has power of the order of 100 W to 300 W, e.g. 150 W to 200 W.

5. A device according to any preceding claim, **characterized in that** the electrical machine (126) has two stators that are electrically connected to the computer (112) via independent paths.

6. A device according to any preceding claim, **characterized in that** the fan (124) includes radial blades of fixed or variable angular pitch.

7. A device according to any preceding claim, **characterized in that** the fan (124) is of the type having variable-pitch blades, the electrical machine (126) including a rotor (142) that is movable in translation inside the stator (140) with one end connected to means (146) for actuating and pivoting the blades about their axes, and with its other end connected to a fly-weight governor (144).

8. A device according to any preceding claim, **characterized in that** the fan (124') is of the variable-pitch blade type, the electrical machine (126') comprising a rotor (142') having one end surrounded by a hub (148') supporting blades and around which a ring (152') is mounted to move in turning and is connected by links (154') to means for pivoting the blades about their respective radial axes, the hub being movable in turning around the rotor, which includes at least one radial finger (150') passing through a circumferential slot (151') in the hub and an orifice (153') of the ring, the angular movement of the ring around the hub being a function of the angular movement of the radial finger of the rotor in the slot of the hub.

9. A device according to claim 8, **characterized in that** the rotor (142') has two diametrically opposite radial fingers (150'), each passing through a respective circumferential slot (151') in the hub (148') and a respective orifice (153') in the ring (152').

10. A method of using a device according to any preceding claim, the method being **characterized in that**, when the aircraft is in flight, air flowing in the feed means (122) passes through and drives rotation of the fan (124), which in turn drives rotation of the rotor of the electrical machine (126) in order to power the computer (112), which is cooled by the air leaving the feed means, and while the aircraft is on the ground, electrical power supply means (116) of the aircraft power the computer and the electrical machine in order to drive the fan so as to generate a stream of ventilation air for the computer.
